(19) Europäisches Patentamt
European Patent Office
Office européen des brevets

(11) **EP 2 337 219 A1**

(12) **EUROPEAN PATENT APPLICATION**

(43) Date of publication:
**22.06.2011 Bulletin 2011/25**

(51) Int Cl.:
*H03H 7/25* (2006.01)    *H03H 11/02* (2006.01)
*H03H 11/24* (2006.01)

(21) Application number: **10173283.2**

(22) Date of filing: **18.08.2010**

(84) Designated Contracting States:
**AL AT BE BG CH CY CZ DE DK EE ES FI FR GB GR HR HU IE IS IT LI LT LU LV MC MK MT NL NO PL PT RO SE SI SK SM TR**
Designated Extension States:
**BA ME RS**

(30) Priority: **14.12.2009 KR 20090123664**

(71) Applicant: **Korea Advanced Institute of Science and Technology**
**305-701 Daejeon (KR)**

(72) Inventors:
• **Hong, Song Cheol**
  **305-301 Daejon (KR)**
• **Ku, Bon Hyun**
  **704-815 Daegu (KR)**

(74) Representative: **Lindroth, Anders et al**
**Kransell & Wennborg KB**
**Box 27834**
**115 93 Stockholm (SE)**

(54) **Digital attenuator having small phase variation**

(57)    Disclosed herein is a digital attenuator, which can improve the variation in the pass phase of the digital attenuator because the difference between parasitic components caused by the turn-on and turn-off operations of the switching transistors of the digital attenuator causes the difference between the pass phases.

The digital attenuator of the present invention includes an attenuation circuit unit configured to cause a variation in a pass phase due to a difference between parasitic components caused by turn-on and turn-off operations of switching transistors, and a phase correction unit connected in parallel with the attenuation circuit unit and provided with a series resistor and a low pass filter.

Accordingly, variations in pass phase can be eliminated by connecting a low pass filter, connected to series resistors, in parallel with the series switch of an attenuation circuit unit, thus eliminating the influence of the parasitic components.

FIG. 3

EP 2 337 219 A1

**Description**

BACKGROUND OF THE INVENTION

1. Field of the Invention

The present invention relates, in general, to a digital attenuator, and, more particularly, to a structure for improving variations in the pass phase of a digital attenuator.

2. Description of the Related Art

A lot of research and development into digital attenuators using switching transistors has been conducted to date. In particular, for application fields requiring low pass phase variation performance, the following research has been conducted.

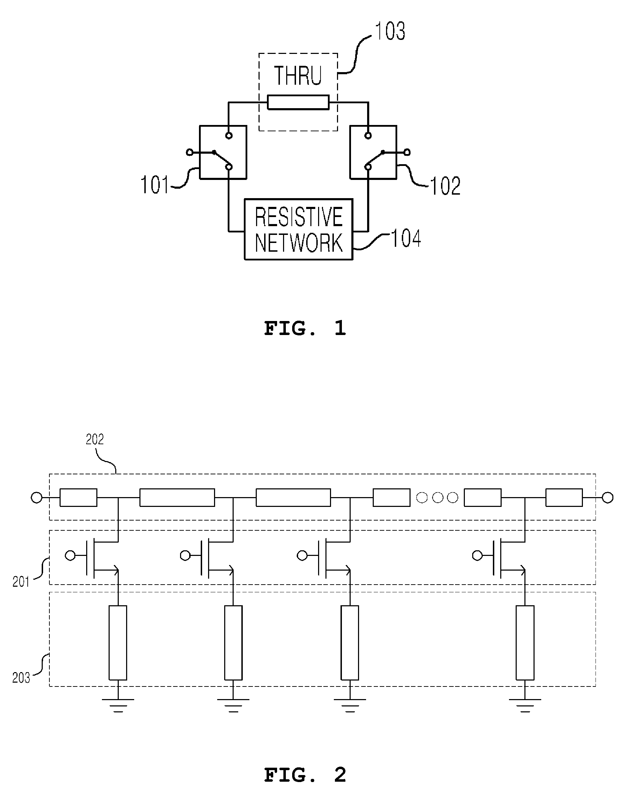

As shown in FIG. 1, according to the conventional technology, two Single-Pole-Double-Throw (SPDT)-type switches 101 and 102 are used, and a reference state part and an attenuation state part are distinguished from each other by a transmission line 103 and by a resistive network 104, respectively, thus enabling the pass phase to be easily corrected.

Further, as shown in FIG. 2, the conventional technology is implemented using a structure in which switching transistors 201 are connected in parallel to a transmission line 202, and attenuation is obtained by turning on or off the switching transistors 201. In this structure, transmission lines 203 having suitable lengths are additionally connected in series with the switching transistors 201, thus reducing variations in the pass phase.

The conventional structure shown in FIG. 1 can easily eliminate a variation in the pass phase, but is disadvantageous because insertion loss is high when used in a substrate having high loss such as a silicon substrate, and is problematic because in order to obtain high attenuation, a plurality of unitary attenuators must be connected in cascade, and insertion losses are accumulated, and thus the net insertion loss greatly increases.

The structure shown in FIG. 2 is configured to obtain a unitary attenuation value via the coupling of transmission lines with unitary parallel switches, so that the number of transmission lines and unitary parallel switches increases in proportion to the degree of attenuation so as to obtain high attenuation, thus greatly increasing the actual size of an implemented circuit.

SUMMARY OF THE INVENTION

Accordingly, the present invention has been made keeping in mind the above problems occurring in the prior art, and an object of the present invention is to provide a digital attenuator, which can improve the variation in the pass phase of the digital attenuator because the difference between parasitic components caused by the turn-on and turn-off operations of the switching transistors of the digital attenuator causes the difference between the pass phases.

In order to accomplish the above object, the present invention provides a digital attenuator having a small phase variation, comprising an attenuation circuit unit configured to cause a variation in a pass phase due to a difference between parasitic components caused by turn-on and turn-off operations of switching transistors; and a phase correction unit connected in parallel with the attenuation circuit unit and provided with a series resistor and a low pass filter.

BRIEF DESCRIPTION OF THE DRAWINGS

FIGS. 1 and 2 are diagrams showing the construction of a conventional digital attenuator;
FIG. 3 is a diagram showing the construction of a Pi-type digital attenuator using a low pass filter according to an embodiment of the present invention;
FIG. 4 is a diagram showing the construction of a T-type digital attenuator using a low pass filter according to an embodiment of the present invention;
FIGS. 5A to 6B are diagrams illustrating the structures of a low pass filter according to embodiments of the present invention;
FIG. 7A is a diagram showing the construction of a Pi-type digital attenuator without a phase correction unit according to an embodiment of the present invention;
FIG. 7B is an equivalent circuit diagram showing the Pi-type digital attenuator without a phase correction unit in consideration of parasitic components in a reference state according to an embodiment of the present invention;
FIG. 7C is an equivalent circuit diagram showing the Pi-type digital attenuator without a phase correction unit in consideration of parasitic components in an attenuation state according to an embodiment of the present invention;

FIG. 8A is a diagram showing the construction of a T-type digital attenuator without a phase correction unit according to an embodiment of the present invention;

FIG. 8B is an equivalent circuit diagram showing the T-type digital attenuator without a phase correction unit in consideration of parasitic components in a reference state according to an embodiment of the present invention;

FIG. 8C is an equivalent circuit diagram showing the T-type digital attenuator without a phase correction unit in consideration of parasitic components in an attenuation state according to an embodiment of the present invention;

FIG. 9 is a graph showing the difference between the phases of the digital attenuator of FIG. 7A in the reference state and in the attenuation state;

FIG. 10A is a diagram showing the construction of a Pi-type digital attenuator using the low pass filter of FIG. 5A;

FIG. 10B is an equivalent circuit diagram showing the Pi-type digital attenuator using the low pass filter of FIG. 5A in consideration of parasitic components in a reference state;

FIG. 10C is an equivalent circuit diagram showing the Pi-type digital attenuator using the low pass filter of FIG. 5A in consideration of parasitic components in an attenuation state;

FIG. 11 is a graph showing the difference between the phases of the Pi-type digital attenuator using the low pass filter of FIG. 5A in the reference state and in the attenuation state;

FIG. 12A is a diagram showing the construction of a Pi-type digital attenuator using the low pass filter of FIG. 5B;

FIG. 12B is an equivalent circuit diagram showing the Pi-type digital attenuator using the low pass filter of FIG. 5B in consideration of the parasitic components in a reference state;

FIG. 12C is an equivalent circuit diagram showing the Pi-type digital attenuator using the low pass filter of FIG. 5B in consideration of parasitic components in an attenuation state; and

FIG. 13 is a graph showing the difference between the phases of the Pi-type digital attenuator using the low pass filter of FIG. 5B in the reference state and in the attenuation state.

## DESCRIPTION OF THE PREFERRED EMBODIMENTS

The above and other objects, features and advantages of the present invention will be more clearly understood from the following detailed description taken in conjunction with the accompanying drawings. In the following description of the present invention, if detailed descriptions of related well-known constructions or functions are determined to make the gist of the present invention unclear, the detailed descriptions will be omitted.

A digital attenuator according to the present invention includes an attenuation circuit unit configured to cause a variation in the pass phase due to the difference between parasitic components caused by the turn-on and turn-off operations of switching transistors, and a phase correction unit connected in parallel with the attenuation circuit unit and provided with series resistors and a low pass filter.

Preferably, the attenuation circuit unit is implemented as a Pi-type structure in which an input terminal is connected to the drain terminal of a series switching transistor and is connected to the drain terminal of a first parallel switching transistor, both the source terminal and body terminal of the first parallel switching transistor are connected to a resistor which is grounded, and in which an output terminal is connected to the source terminal and the body terminal of the series switching transistor and is connected to the drain terminal of a second parallel switching transistor, and the source terminal and the body terminal of the second parallel switching transistor are connected to a resistor which is grounded.

Preferably, the attenuation circuit unit may be implemented as a T-type structure in which an input terminal is connected to the drain terminal of a series switching transistor and is connected to a first series resistor and in which an output terminal is connected to the source terminal and the body terminal of the series switching transistor and to a second series resistor, the drain terminal of a parallel switching transistor is connected between the first and second series resistors, and the source terminal and the body terminal of the parallel switching transistor are connected to a resistor which is grounded.

Preferably, the low pass filter may be implemented as a series inductor or a parallel capacitor.

More preferably, the low pass filter may be implemented such that a series inductor, a parallel capacitor and another series inductor are connected in a T shape.

More preferably, the low pass filter may be implemented such that a parallel capacitor, a series inductor and another parallel capacitor are connected in a Pi shape.

Further, more preferably, the phase correction unit is implemented such that one terminal thereof is connected to the drain terminal of the series switching transistor of the attenuation circuit unit and the other terminal thereof is connected to the source terminal and the body terminal of the series switching transistor.

Hereinafter, embodiments of the present invention will be described in detail with reference to the attached drawings.

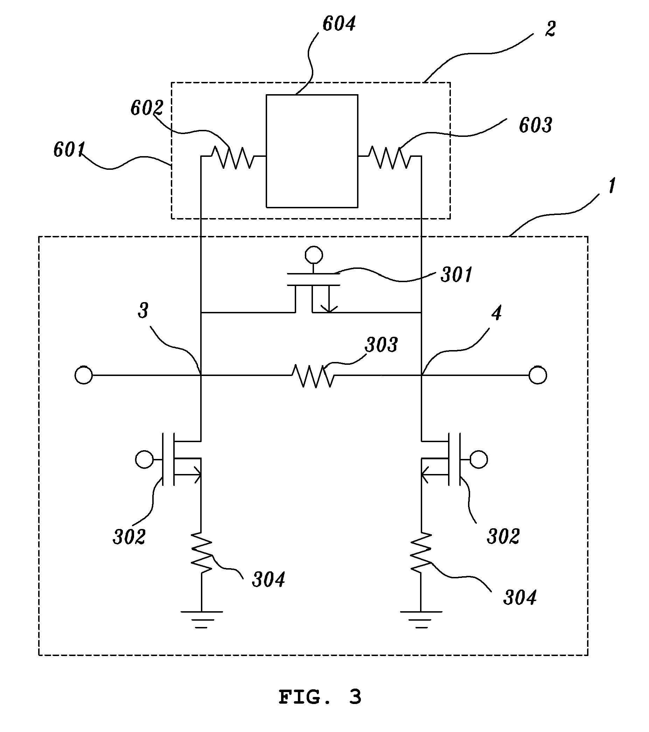

FIG. 3 is a diagram showing the construction of a Pi-type digital attenuator using a low pass filter according to an embodiment of the present invention.

As shown in FIG. 3, the digital attenuator according to the embodiment of the present invention is a Pi-type digital attenuator using a low pass filter. In the structure of the digital attenuator, a phase correction unit 601 is connected in parallel with a series switching transistor 301 in an attenuation circuit unit 1 composed of the series switching transistor 301, parallel switching transistors 302, and a series resistor 303 and parallel resistors 304 which constitute a resistive network.

Here, the phase correction unit 601 of the Pi-type digital attenuator is a circuit which includes a low pass filter 604 and series resistors 602 and 603 connected in series with the filter 604. Such a phase correction unit 601 is connected in parallel with the series switching transistor 301 of the Pi-type attenuation circuit unit 1, thus forming the structure of the present invention. In this case, the series resistors 602 and 603 of the phase correction unit 601 may also be implemented as a single resistor. Further, the series resistors 602 and 603 may replace the function of the series resistor 303 constituting the resistive network of the Pi-type digital attenuator, and thus the series resistor 303 can be omitted.

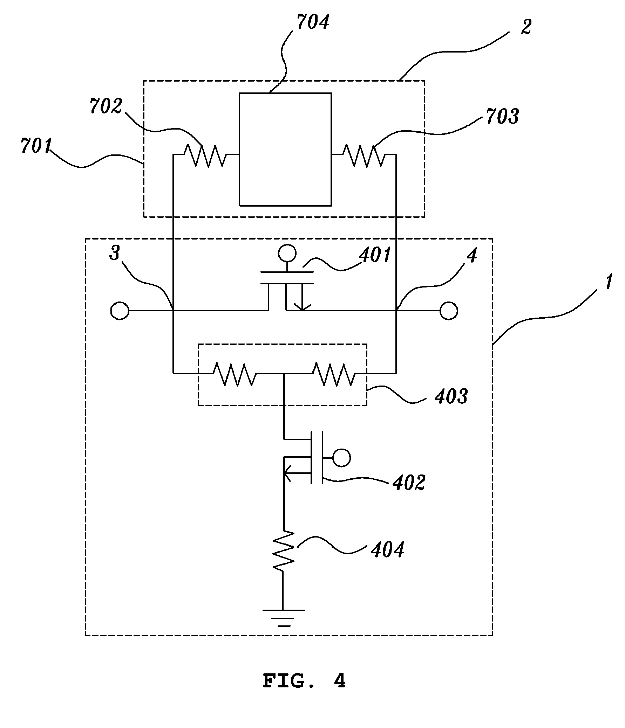

FIG. 4 is a diagram showing the construction of a T-type digital attenuator using a low pass filter according to an embodiment of the present invention.

As shown in FIG. 4, a digital attenuator according to another embodiment of the present invention is a T-type digital attenuator using a low pass filter. The structure of the digital attenuator is configured such that a phase correction unit 701 is connected in parallel with a series switching transistor 401 in an attenuation circuit unit 1 composed of the series switching transistor 401, a parallel switching transistor 402, and series resistors 403 and a parallel resistor 404 which constitute a resistive network.

Here, the phase correction unit 701 of the T-type digital attenuator is a circuit which includes a low pass filter 704 and series resistors 702 and 703 connected in series with the filter 704. Such a phase correction unit 701 is connected in parallel with the series switching transistor 401 of the T-type attenuation circuit unit 1, thus forming the structure of the present invention. In this case, it is apparent that the series resistors 702 and 703 of the phase correction unit 701 may be implemented as a single resistor.

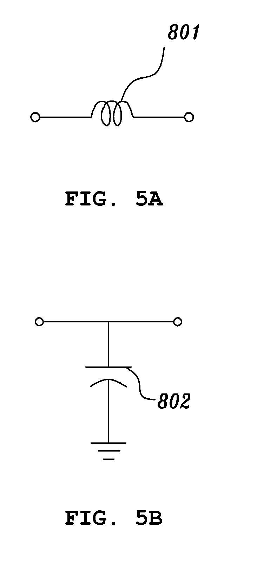

FIGS. 5A to 6B are diagrams illustrating the structures of the low pass filter according to embodiments of the present invention.

When the low pass filter 604 or 704 according to the embodiment of the present invention is implemented using a single element, it may have a first structure (refer to FIG. 5A) implemented using one series inductor 801 or a second structure (refer to FIG. 5B) implemented using one parallel capacitor 802.

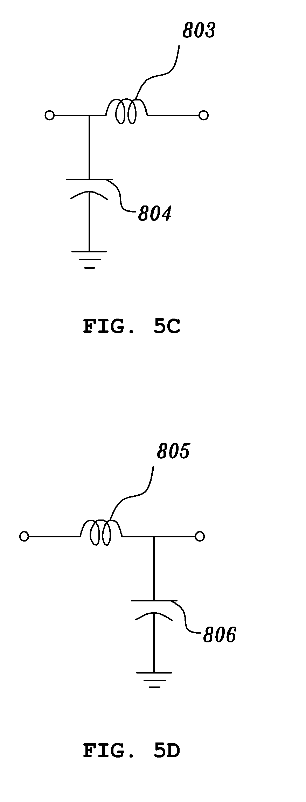

Further, when the low pass filter according to the embodiment of the present invention is implemented using two elements, it may have a third structure (refer to FIG. 5C) in which one series inductor 803 is connected to one parallel capacitor 804 connected to an input terminal, or a fourth structure (refer to FIG. 5D) in which one series inductor 805 is connected to one parallel capacitor 806 connected to an output terminal.

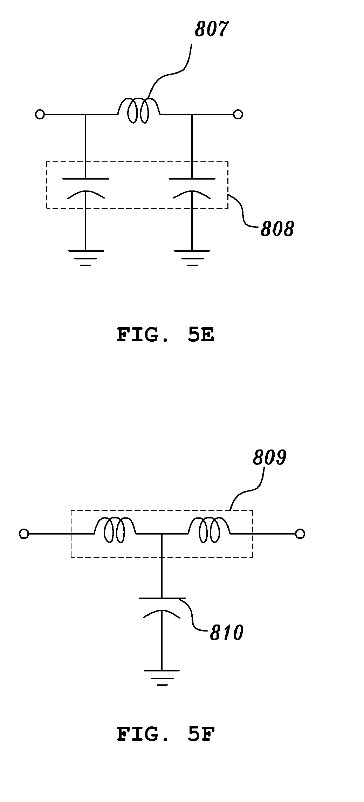

Furthermore, when the low pass filter according to the embodiment of the present invention is implemented using three elements, it may have a fifth structure (refer to FIG. 5E) in which one series inductor 807 is provided and two capacitors 808 are connected in parallel with both ends of the series inductor 807, or a sixth structure (refer to FIG. 5F) in which two series inductors 809 are provided and a parallel capacitor 810 is connected between the two series inductors 809.

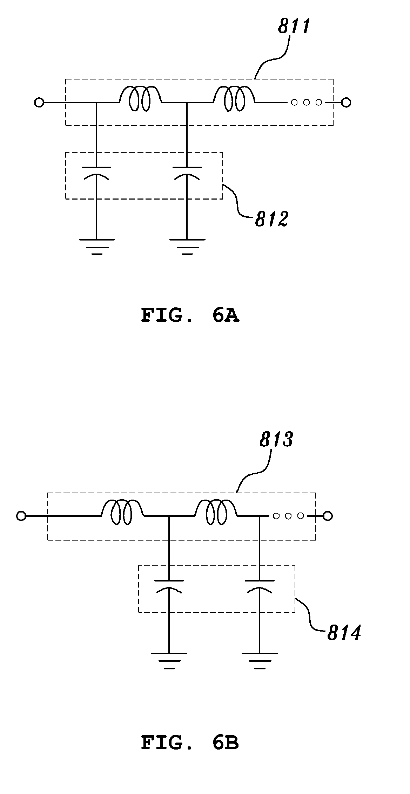

Furthermore, when the low pass filter according to the embodiment of the present invention is implemented using four or more elements, it may have a seventh structure (refer to FIG. 6A) including two or more series inductors 811 and two or more parallel capacitors 812, with an input terminal connected to a parallel capacitor, or an eighth structure (refer to FIG. 6B) including two or more series inductors 813 and two or more parallel capacitors 814, with the input terminal connected to a series inductor.

In order to prove the effects of the digital attenuator according to embodiments of the present invention, how the variation in the pass phase can be reduced will be described below using theoretical calculations.

First, the variation in the pass phase of a Pi-type digital attenuator without a phase correction unit according to an embodiment of the present invention will be theoretically described as follows.

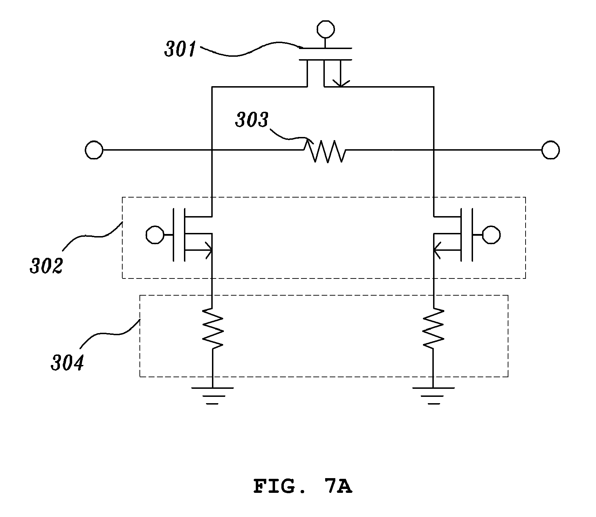

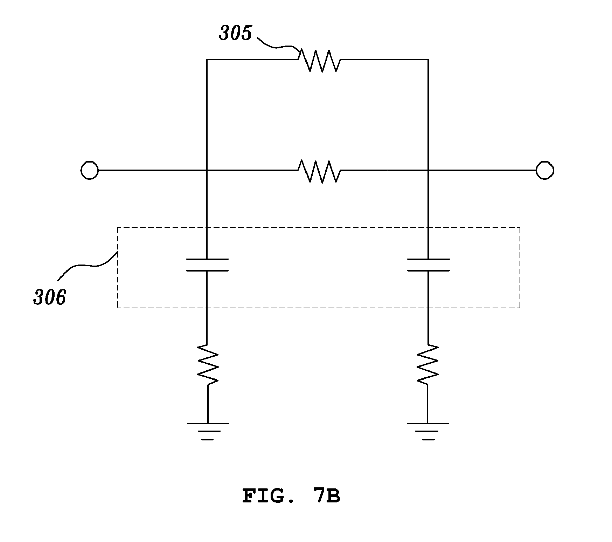

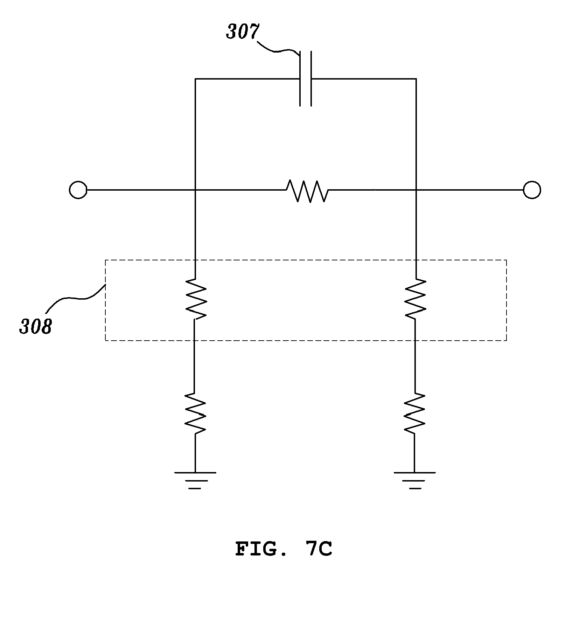

FIG. 7A is a diagram showing the construction of a Pi-type digital attenuator without a phase correction unit, FIG. 7B is an equivalent circuit diagram showing the Pi-type digital attenuator without a phase correction unit in consideration of parasitic components in a reference state, and FIG. 7C is an equivalent circuit diagram showing the Pi-type digital attenuator without a phase correction unit in consideration of parasitic components in an attenuation state.

As shown in FIG. 7A, the structure of the Pi-type digital attenuator without a phase correction unit according to the present embodiment is configured to include a series switching transistor 301, parallel switching transistors 302, and a series resistor 303 and parallel resistors 304 which constitute a resistive network. In this structure, a variation in pass phase occurs due to the difference between the parasitic components caused by the turn-on and turn-ff operations of the switching transistors.

As shown in FIG. 7B, in an attenuation-free reference state, the series switching transistor is turned on, and the parallel switching transistors are turned off, so that the parasitic capacitances act as a predominating component.

In such a reference state, since the ON-resistance 305 of the transistor shown as a series resistor is small, a variation in the phase of a pass signal is not large. However, as shown in FIG. 7C, in the attenuation state, the series switch is turned off, so that parasitic capacitance 307 between the input and output terminals acts as a predominating parasitic component, and the parallel switching transistors are turned on, and thus the parasitic capacitance is connected to the ground via resistances connected in series with the ON-resistances 308.

In this attenuation state, the phase of a signal passing through the output terminal precedes that of an input signal due to the series-connected parasitic capacitances. Therefore, the phase in the attenuation state precedes that in the reference state, thus causing a variation in the phase of the pass signal. When the degree of desired attenuation is very high, the attenuator is designed so that the resistance of the series resistor 303 of the resistive network is very high and the resistance of the parallel resistors 304 is very low. Therefore, since the influence of parasitic capacitance caused by the turn-off operation of the series switch in the attenuation state becomes more predominant, the variation in the pass phase is further increased.

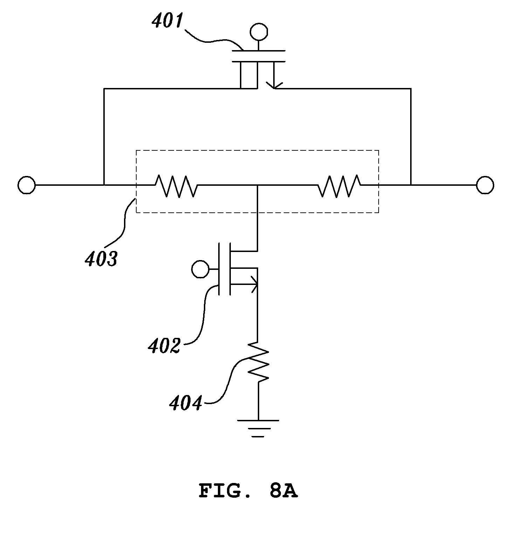

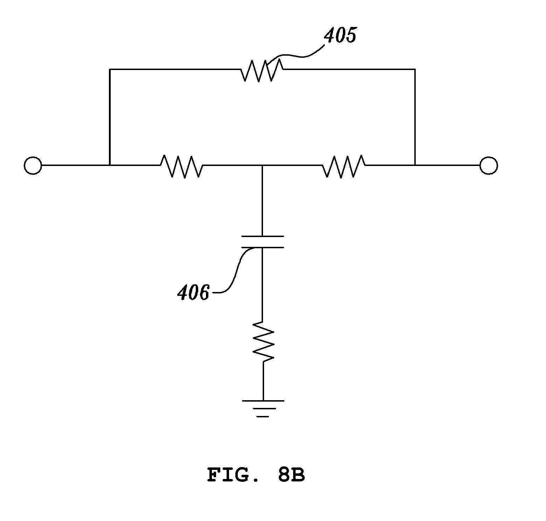

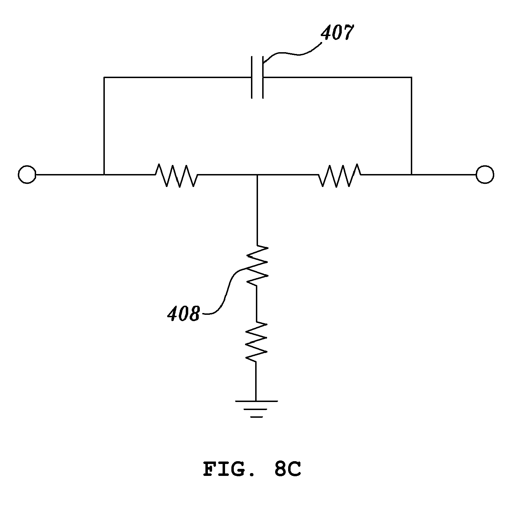

FIG. 8A is a diagram showing the construction of a T-type digital attenuator without a phase correction unit, FIG. 8B is an equivalent circuit diagram showing the T-type digital attenuator without a phase correction unit in consideration of parasitic components in a reference state, and FIG. 8C is an equivalent circuit diagram showing the T-type digital attenuator without a phase correction unit in consideration of parasitic components in an attenuation state.

As shown in FIGS. 8A to 8C, the T-type digital attenuator without a phase correction unit according to the present embodiment is configured to include a series switching transistor 401, a parallel switching transistor 402, and series resistors 403 and a parallel resistor 404 which constitute a resistive network. Similarly to the Pi-type structure, even in the T-type structure, a variation in the pass phase occurs due to the difference between the parasitic components caused by the turn-on and turn-off operations of the switching transistors. Similarly, difference in the pass phase occurs due to the difference between the parasitic components in the reference state and in the attenuation state.

Such a variation in the pass phases of the Pi-type and T-type structures without a phase correction unit is more clearly verified using theoretical calculations.

Referring to the Pi-type structure of FIG. 7A, when the pass phases in the reference state and in the attenuation state are individually derived from transmission matrixes, they can be represented by the following Equations (1) and (2), respectively, where $\omega^2 C_2^2 R_p^2 \ll 1$ is assumed.

$$\phi_R = \tan^{-1}\left(\frac{2(R_1R_s + Z_0R_s + Z_0R_1)C_2\omega Z_0}{2Z_0R_s + 2Z_0R_1 + 2R_1R_s}\right) \tag{1}$$

$$\phi_A = \tan^{-1}\left(\frac{\omega C_1 R_s^2 (R_p + Z_0)}{R_sR_p + Z_0R_s + 2Z_0R_p}\right) \tag{2}$$

The variables used in the above Equations are defined such that in FIG. 7A, $R_1$ is the ON-resistance 305 of the transistor 301 and $C_1$ is the OFF-capacitance 307 of the transistor 301, and such that $R_2$ is the ON-resistance 308 of the transistors 302 and $C_2$ is the OFF-capacitance 306 of the transistors 302. Further, $R_s$ is the resistance of the series resistor 303 of the resistive network, and $R_p$ is the resistance of the parallel resistors 304. $Z_0$ is characteristic impedance and $\omega$ is the frequency.

In order to eliminate the difference between the pass phases, the following Equation (3) must be satisfied. Further, when solutions satisfying Equation (3) are obtained as the values of $C_1$ and $C_2$, they are given by the following Equations (4) and (5), respectively.

$$\Delta\phi = \phi_A - \phi_R = 0 \tag{3}$$

$$C_1 = -\frac{2C_2Z_0(R_1R_s + Z_0R_s + Z_0R_1)(R_2R_s + R_sR_p + 2Z_0R_2 + Z_0R_s + 2Z_0R_p)}{R_s^2(2Z_0R_s + 2Z_0R_1 + R_1R_s)(R_2 + R_p + Z_0)} \tag{4}$$

$$C_2 = -\frac{C_1 R_s^2 (2Z_0 R_s + 2Z_0 R_1 + R_1 R_s)(R_2 + R_p + Z_0)}{2Z_0 (R_1 R_s + Z_0 R_s + Z_0 R_1)(R_2 R_s + R_s R_p + 2Z_0 R_2 + Z_0 R_s + 2Z_0 R_p)} \qquad (5)$$

Since all variables including $C_1$ and $C_2$ have positive values, values that satisfy $C_1$ and $C_2$ of Equations (4) and (5) cannot be theoretically obtained. Therefore, the Pi-type and T-type structures without a phase correction unit cannot theoretically completely eliminate the variation in the pass phase.

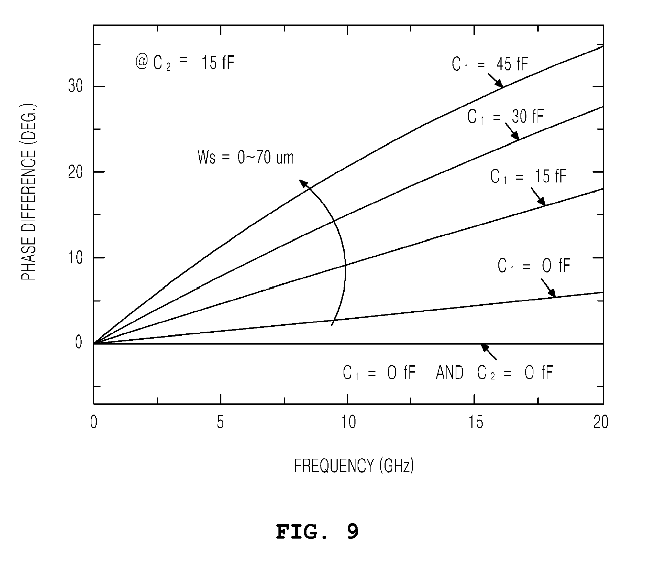

FIG. 9 shows the difference between phases in the reference state and in the attenuation state in the form of a graph when the resistances of the series and parallel resistors of the resistive network are set to 154 Ω and 29 Ω, respectively, the capacitance $C_1$ is fixed at 15 fF, and the capacitance $C_2$ is varied in a range from 0 to 45fF, in order to obtain 16dB attenuation.

As shown in FIG. 9, in order to completely eliminate the phase variation, both $C_1$ and $C_2$ must be 0 fF. This means that the parasitic components of switching transistors manufactured by a semiconductor manufacturing process must be completely eliminated, and thus this is a realistically impossible condition.

Next, in order to prove the effects of the digital attenuator to which a phase correction unit is applied according to an embodiment of the present invention, how the variation in the pass phase can be reduced will be described below using theoretical calculations.

In the construction of the phase correction unit according to the present embodiment, when a simple low pass filter is assumed, equations are developed using a low pass filter implemented as a single element such as a series inductor or a parallel capacitor.

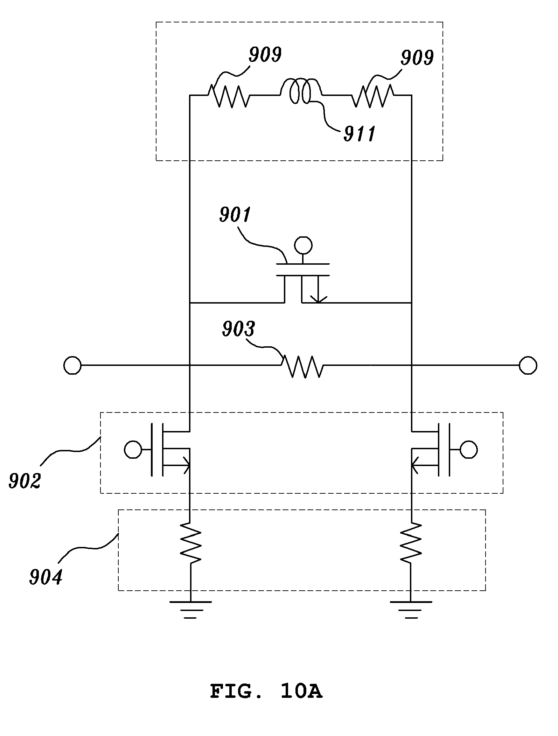

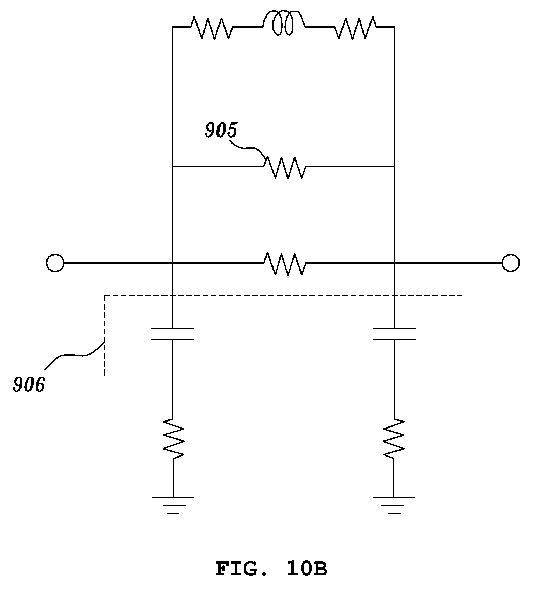

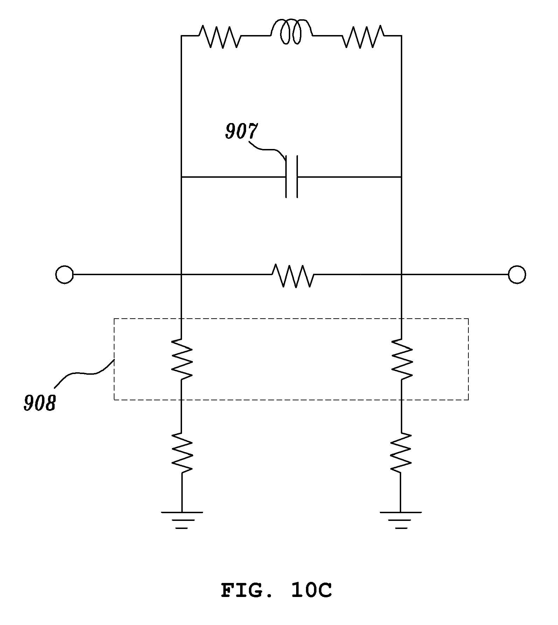

FIG. 10A is a diagram showing the construction of a Pi-type digital attenuator using the low pass filter of FIG. 5A, FIG. 10B is an equivalent circuit diagram showing the Pi-type digital attenuator using the low pass filter of FIG. 5A in consideration of parasitic components in a reference state, and FIG. 10C is an equivalent circuit diagram showing the Pi-type digital attenuator using the low pass filter of FIG. 5A in consideration of parasitic components in an attenuation state.

In the structure of the Pi-type digital attenuator in which the low pass filter according to an embodiment of the present invention is implemented using one element, that is, the series inductor, as shown in FIG. 5A, when the pass phase $\phi_R$ in the reference state and the pass phase $\phi_A$ in the attenuation state are individually derived from transmission matrixes, they can be represented by the following Equations (6) and (7), respectively.

Here, $\omega^2 C_2^2 R_p^2 \ll 1$ and $\omega^2 C_1^2 R_c^2 \ll 1$ are assumed.

$$\phi_R = -\tan^{-1}\left(\frac{\omega(2Z_0 C_2 (4R_c^2(Z_0 + R_1) + 2R_c R_1(R_1 + 4Z_0) + Z_0 R_1^2) + L_c(R_1^2 + 2\omega^2 L_c C_2 Z_0(Z_0 + R_1)))}{4R_c^2(R_1 + 2Z_0) + 2R_c R_1(R_1 + 4Z_0) + 2Z_0 R_1^2 - \omega^2 L_c(2C_2 R_1^2 Z_0 - L_c R_1 - 2L_c Z_0)}\right)$$

$$(6)$$

$$\phi_A = \tan^{-1}\left(\frac{\omega(4C_1 R_c^2 + 3\omega^2 L_c^2 C_1 - L_c)(R_p + Z_0)}{2(R_c R_p + Z_0 R_c + 2Z_0 R_p)(1 - 2\omega^2 L_c C_1)}\right) \qquad (7)$$

Referring to FIGS. 10A, 10B and 10C, the variables used in Equations are defined such that $R_1$ is the ON-resistance 905 of the series switching transistor 901, $C_1$ is the OFF-capacitance of the series switching transistor 901, $R_2$ is the resistance of the series resistor 903 of the resistive network, $R_p$ is the resistance of parallel resistors 904, $L_c$ is the inductance of a series inductor 911, and $R_c$ is the resistance of the series resistors 909 and 910 of a phase correction unit. $Z_0$ is characteristic impedance and $\omega$ is the frequency.

In order to eliminate the difference between pass phases, the above-described Equation (3), that is, $\Delta\phi = \phi_A - \phi_R = 0$, must be satisfied. Further, when solutions satisfying Equation (3) are obtained as the value of $L_c$, the following Equation (8) is obtained.

$$L_c = \frac{1 - \sqrt{1 - 16\omega R_c^2 C_1^2}}{2\omega^2 C_1} \tag{8}$$

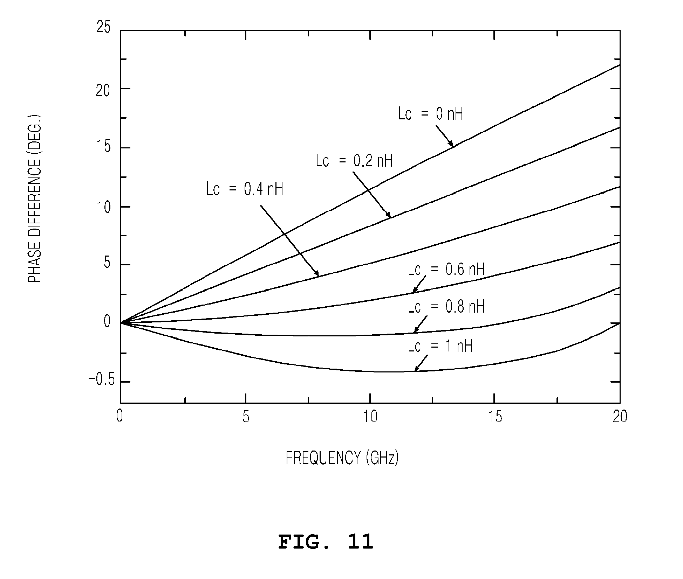

The value satisfying $L_c$ in Equation (8) can be theoretically obtained. In FIG. 11, the resistive network is set to have 16dB attenuation. However, the function of the series resistor 903 is assigned to the resistors 909 and 910 of FIG. 10A without the series resistor 903 being used, so that the resistance of each of the resistors 909 and 910 is set to 77 $\Omega$ and the resistance of each of the parallel resistors is set to 35 $\Omega$. Here, FIG. 11 shows the difference between the phases in the reference state and in the attenuation state in the form of a graph when $C_1$ is fixed at 21 fF, $C_2$ is fixed at 15 fF, and $L_c$ is varied in a range from 0 to 1 nH. As shown in FIG. 11, it can be seen that a phase variation can be completely eliminated at the specific value of $L_c$.

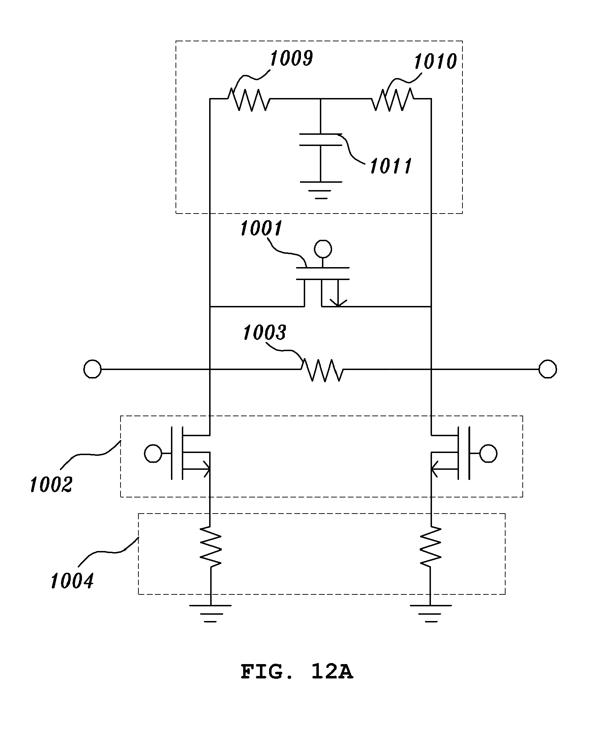

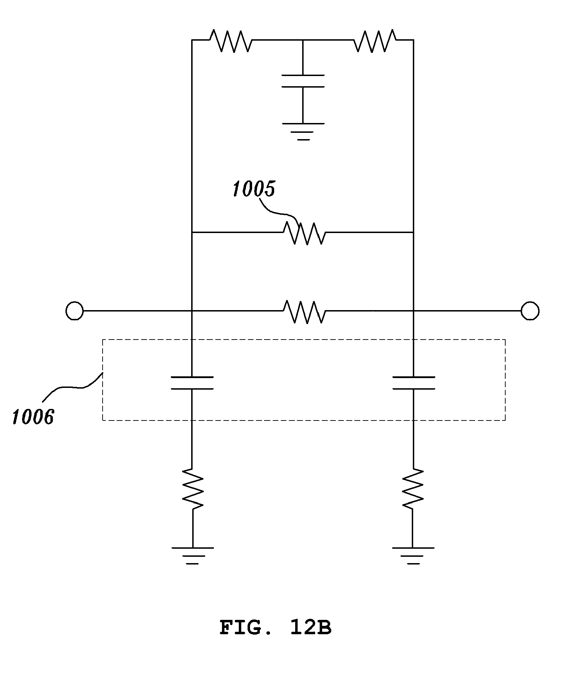

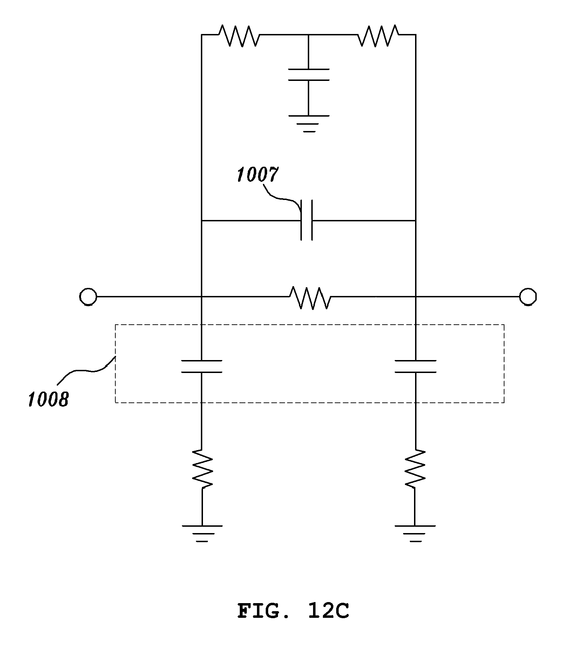

FIG. 12A is a diagram showing the construction of a Pi-type digital attenuator using the low pass filter of FIG. 5B, FIG. 12B is an equivalent circuit diagram showing the Pi-type digital attenuator using the low pass filter of FIG. 5B in consideration of parasitic components in a reference state, and FIG. 12C is an equivalent circuit diagram showing the Pi-type digital attenuator using the low pass filter of FIG. 5B in consideration of parasitic components in an attenuation state.

In the structure of the Pi-type digital attenuator in which the low pass filter according to the embodiment of the present invention is implemented as a single element, that is, the parallel capacitor, as shown in FIG. 5B, when the pass phase $\phi_R$ in the reference state and the pass phase $\phi_A$ in the attenuation state are individually derived from transmission matrixes, they can be represented by the following Equations (9) and (10), respectively.

Here, $\omega^2 C_2^2 R_p^2 \ll 1$ and $\omega^2 C_1^2 R_c^2 \ll 1$ are assumed,

$$\phi_R = -\tan^{-1}\left(\frac{\omega(2Z_0 C_2(R_1 + 2R_c)(2R_1 R_c + 2Z_0 R_c + Z_0 R_1) + C_c(R_1 R_c + 2Z_0 R_c + Z_0 R_1)^2)}{2(R_1 + 2R_c)(R_1 R_c + 2Z_0 R_c + Z_0 R_1)}\right) \tag{9}$$

$$\phi_A = \tan^{-1}\left(\frac{\omega(4C_1 R_c^2(R_p + Z_0)^2 - C_c(\,R_c R_p + Z_0 R_c + Z_0 R_p)^2 - \omega C_1 R_c^2 M)\,)}{(R_p + Z_0)(R_c R_p + Z_0 R_c + Z_0 R_p) + \omega R_c^2 C_c C_1(3Z_0 R_p^2 + 6Z_0 R_c R_p + 4R_c R_p^2 + 4Z_0^2 R_c + 4Z_0^2 R_p)}\right) \tag{10}$$

where parameter $M$ in the above Equation (9) is represented by the following Equation (11).

$$M = 2C_1 R_c(4R_c(R_p + Z_0)^2 - Z_0 R_p(4R_c - R_p)\,) - C_c(2(R_c^2 R_p^2 + Z_0^2 R_c^2 + Z_0^2 R_p^2) + Z_0 R_c R_p(3R_c + 3R_p + 4Z_0)\,)\,)$$

The variables used in the Equations are defined such that in FIGS. 12A to 12C, $R_1$ is the ON-resistance 1005 of a transistor 1001 and $C_1$ is the OFF-capacitance 1007 of the transistor 1001, and such that $R_2$ is the ON-resistance 1008 of transistors 1002 and $C_2$ is the OFF-capacitance 1006 of the transistors 1002. Further, $R_s$ is the resistance of the series resistor 1003 of a resistive network and $R_p$ is the resistance of the parallel resistors 1004 of the resistive network. $C_c$ is the capacitance of a parallel capacitor 1011 and $R_c$ is the resistance of each of resistors 1009 and 1010. $Z_0$ is characteristic impedance and $\omega$ is the frequency.

In order to eliminate the difference between pass phases, the above-described Equation (3) must be satisfied. Further, when the solution satisfying Equation (3) is obtained as the value of $C_c$, it is given by the following Equation (12).

$$C_c = \frac{R_c + Z_0 - 2\omega^2 C_1^2 Z_0 R_c R_1 - \sqrt{(R_c + Z_0)^2 - 4\omega^2 C_1^2 R_c(4R_c^3 + 2R_c^2(R_1 + 2Z_0) - 3Z_0 R_1 R_c + Z_0^2 R_1 - \omega^2 C_1^2 Z_0^2 R_1^2 R_c}}{2\omega^2 C_1 R_c(R_c + Z_0)}$$

$$\tag{12}$$

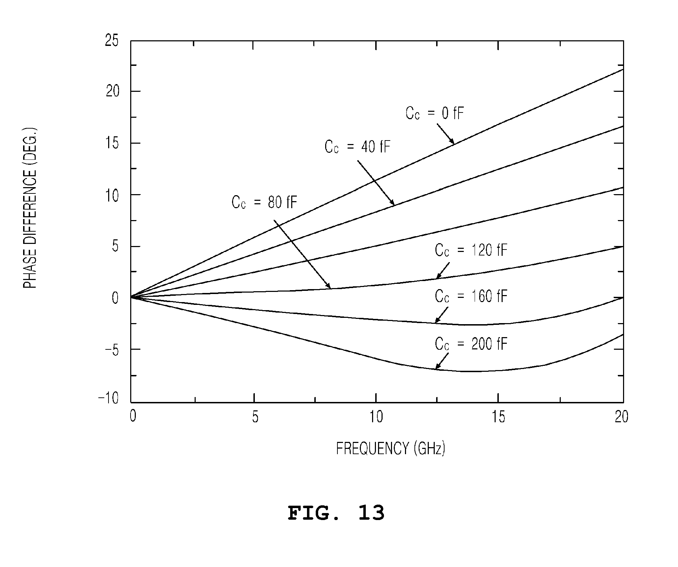

The value satisfying $C_c$ in Equation (12) can be theoretically obtained. In FIG. 13, the resistive network is set to have 16dB attenuation. However, the function of the series resistor 1003 is assigned to the resistors 1009 and 1010 of FIG. 12A without the series resistor 1003 being used, so that the resistance of each of the resistors 1009 and 1010 is set to 77 Ω, and the resistance of each of the parallel resistors is set to 35 Ω. FIG. 13 shows the difference between the phases in the reference state and in the attenuation state in the form of a graph when $C_1$ and $C_2$ are fixed at 21 fF and 15 fF, respectively, and $C_c$ is varied in a range from 0 to 200 fF. As shown in FIG. 13, it can be seen that a phase variation can be completely eliminated at the specific value of $C_c$.

As descried above, the present invention is advantageous in that, since the difference between parasitic components caused by the turn-on and turn-off operations of switching transistors causes the difference between pass phases, such a variation in the pass phase can be eliminated by connecting a low pass filter, connected to series resistors, in parallel with the series switch of an attenuation circuit unit, thus eliminating the influence of the parasitic components.

Further, the present invention is advantageous in that a low pass filter can be implemented using only one series inductor or one parallel capacitor disposed between input and output terminals, and can also be implemented as filters having various types of structures by utilizing inductors together with capacitors and expanding on a simple filter structure.

Furthermore, the present invention is advantageous in that in the case of a low pass filter implemented using only one parallel capacitor, the variation in the pass phase can be eliminated without increasing the area of Integrated Circuits (IC) in practice.

Although the preferred embodiments of the present invention have been disclosed for illustrative purposes, those skilled in the art will appreciate that various modifications, additions and substitutions are possible, without departing from the scope and spirit of the invention as disclosed in the accompanying claims. Therefore, all suitable modifications, changes and equivalents should be interpreted as being included in the scope of the present invention.

**Claims**

1. A digital attenuator having a small phase variation, comprising:

   an attenuation circuit unit configured to cause a variation in a pass phase due to a difference between parasitic components caused by turn-on and turn-off operations of switching transistors; and
   a phase correction unit connected in parallel with the attenuation circuit unit and provided with a series resistor and a low pass filter.

2. The digital attenuator according to claim 1, wherein the attenuation circuit unit is implemented as a Pi-type structure in which:

   an input terminal is connected to a drain terminal of a series switching transistor and is connected to a drain terminal of a first parallel switching transistor, and both a source terminal and a body terminal of the first parallel switching transistor are connected to a resistor which is grounded, and
   an output terminal is connected to a source terminal and a body terminal of the series switching transistor and is connected to a drain terminal of a second parallel switching transistor, and both a source terminal and a body terminal of the second parallel switching transistor are connected to a resistor which is grounded.

3. The digital attenuator according to claim 1, wherein the attenuation circuit unit is implemented as a T-type structure in which:

   an input terminal is connected to a drain terminal of a series switching transistor and is connected to a first series resistor,
   an output terminal is connected to a source terminal and a body terminal of the series switching transistor and is connected to a second series resistor, and
   a drain terminal of a parallel switching transistor is connected between the first and second series resistors and both a source terminal and a body terminal of the parallel switching transistor are connected to a resistor which is grounded.

4. The digital attenuator according to claim 1, wherein the low pass filter is implemented using a series inductor or a parallel capacitor.

5. The digital attenuator according to claim 1 or 4, wherein the low pass filter is implemented such that a series inductor, a parallel capacitor and another series inductor are connected in a T shape.

6. The digital attenuator according to claim 1 or 4, wherein the low pass filter is implemented such that a parallel capacitor, a series inductor and another parallel capacitor are connected in a Pi shape.

7. The digital attenuator according to any one of claims 1 to 3, wherein the phase correction unit is implemented such that a first terminal thereof is connected to the drain terminal of the series switching transistor of the attenuation circuit unit and a second terminal thereof is connected to the source terminal and the body terminal of the series switching transistor.

**FIG. 1**

**FIG. 2**

FIG. 3

**FIG. 4**

801

FIG. 5A

802

FIG. 5B

*803*

*804*

FIG. 5C

*805*

*806*

FIG. 5D

*807*

*808*

**FIG. 5E**

*809*

*810*

**FIG. 5F**

FIG. 6A

FIG. 6B

FIG. 7A

FIG. 7B

FIG. 7C

FIG. 8A

*405*

*406*

FIG. 8B

FIG. 8C

**FIG. 9**

FIG. 10A

FIG. 10B

FIG. 10C

FIG. 11

FIG. 12A

FIG. 12B

1007

1008

FIG. 12C

FIG. 13

Europäisches
Patentamt

European
Patent Office

Office européen
des brevets

**EUROPEAN SEARCH REPORT**

Application Number

EP 10 17 3283

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | DE 101 30 764 C1 (EADS DEUTSCHLAND GMBH [DE]) 7 November 2002 (2002-11-07)<br>* paragraph [0029] - paragraph [0032]; figure 3 *<br>----- | 1-7 | INV.<br>H03H7/25<br>H03H11/02<br>H03H11/24 |
| X | US 2001/033206 A1 (CONSTANTINE CORNELIUS [US] ET AL) 25 October 2001 (2001-10-25)<br>* paragraph [0027]; figure 6 *<br>----- | 1-7 | |
| X | US 4 890 077 A (SUN HORNG-JYE [US])<br>26 December 1989 (1989-12-26)<br>* column 9, line 22 - column 9, line 52; figures 2,4d,9 *<br>----- | 1-7 | |
| A | US 5 049 841 A (COOPER PAUL D [US] ET AL)<br>17 September 1991 (1991-09-17)<br>* abstract; figure 1 *<br>----- | 1-7 | |
| A | WO 03/088477 A1 (MITSUBISHI ELECTRIC CORP [JP]; TANIGUCHI EIJI [JP]; SAWAUMI CHIEMI [JP] 23 October 2003 (2003-10-23)<br>* abstract; figures 2,10 *<br>----- | 1-7 | TECHNICAL FIELDS SEARCHED (IPC)<br><br>H03H |

The present search report has been drawn up for all claims

| Place of search | Date of completion of the search | Examiner |
|---|---|---|
| Munich | 31 March 2011 | Kreutz, Joseph |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons

& : member of the same patent family, corresponding
   document

EPO FORM 1503 03.82 (P04C01)

## ANNEX TO THE EUROPEAN SEARCH REPORT
## ON EUROPEAN PATENT APPLICATION NO.

EP 10 17 3283

This annex lists the patent family members relating to the patent documents cited in the above-mentioned European search report.
The members are as contained in the European Patent Office EDP file on
The European Patent Office is in no way liable for these particulars which are merely given for the purpose of information.

31-03-2011

| Patent document cited in search report | | Publication date | Patent family member(s) | | Publication date |
|---|---|---|---|---|---|
| DE 10130764 | C1 | 07-11-2002 | AT<br>EP<br>ES<br>US | 422113 T<br>1278303 A2<br>2320200 T3<br>2003016093 A1 | 15-02-2009<br>22-01-2003<br>20-05-2009<br>23-01-2003 |
| US 2001033206 | A1 | 25-10-2001 | NONE | | |
| US 4890077 | A | 26-12-1989 | EP | 0390120 A2 | 03-10-1990 |
| US 5049841 | A | 17-09-1991 | NONE | | |
| WO 03088477 | A1 | 23-10-2003 | JP<br>JP | 4214710 B2<br>2003309454 A | 28-01-2009<br>31-10-2003 |

EPO FORM P0459

For more details about this annex : see Official Journal of the European Patent Office, No. 12/82